(19) **Europäisches Patentamt / European Patent Office / Office européen des brevets**

(11) **EP 1 983 348 B1**

(12) **EUROPÄISCHE PATENTSCHRIFT**

(45) Veröffentlichungstag und Bekanntmachung des Hinweises auf die Patenterteilung:
**17.02.2010   Patentblatt 2010/07**

(51) Int Cl.:
*G01R 19/165* *(2006.01)*      *H02H 9/02* *(2006.01)*

(21) Anmeldenummer: **07007723.5**

(22) Anmeldetag: **16.04.2007**

(54) **Schaltung zur Laststrom-Messung, -Begrenzung und -Schaltung**

Circuit for measuring, limiting and switching a load current

Circuit pour mesurer, limiter et commuter un courant de charge

(84) Benannte Vertragsstaaten:
**DE FR GB IT**

(43) Veröffentlichungstag der Anmeldung:
**22.10.2008   Patentblatt 2008/43**

(73) Patentinhaber: **SIEMENS AKTIENGESELLSCHAFT**
**80333 München (DE)**

(72) Erfinder: **Schwabe, Dietmar**
**08496 Neumark (DE)**

(56) Entgegenhaltungen:
**DE-A1- 10 226 082      US-A1- 2003 169 025**
**US-B1- 6 285 177      US-B1- 6 316 967**

**Beschreibung**

Die Erfindung betrifft eine Schaltung zur Messung, Begrenzung und Schaltung eines Laststromes an einer Last.

Eine derartige Schaltung kommt auf Gebieten zum Einsatz, wo ein Kurzschluss- bzw. Überstrom an einer Last gemessen und der Laststrom begrenzt werden soll, während gleichzeitig über ein beispielsweise binäres Signal von einem Controller die Last stromlos geschaltet werden können soll.

Bekannte derartige Schaltungen lösen die genannten Aufgaben z.B. mittels Optokoppler, wobei hier die Genauigkeit gering und der Streubereich der Messung relativ hoch ist. Zudem ist hier eine gleichzeitige Abschaltung der Ausgangstreiber (Last) nicht möglich und wird durch Abschalten einer Referenzspannung gelöst.

Aus der deutschen Offenlegungsschrift DE 102 26 082 A1 ist eine Schaltungsanordnung zur Strombegrenzung bekannt. Es wird eine Schaltungsanordnung zur Strombegrenzung eines Stromes durch eine Ausgangsstufe mit einem steuerbaren Leistungsschalter, dessen Laststrecke in Reihe zu einer Messimpedanz und zwischen einem ersten und einem zweiten Anschluss angeordnet ist offenbart. Ein Stromspiegel mit Referenzströmen wird eingesetzt. Eingangsseitig ist der Stromspiegel mit einer Ausgangsstufe verbunden.

In der US 6,316,967 B1 ist eine Strombegrenzungsschaltung mit einem ersten Stromspiegel und einem zweiten Stromspiegel offenbart. Über eine Spannungsüberwachung wird mittels des zweiten Stromspiegels eine Ausgangsspannung konstant gehalten und mit dieser Ausgangsspannung ein Laststrom durch eine Last gesteuert.

Der Erfindung liegt die Aufgabe zugrunde, die bekannten Schaltungen derart zu verbessern, dass eine hohe Genauigkeit in der Strommessung mit einer niedrigen Streuung erreicht wird.

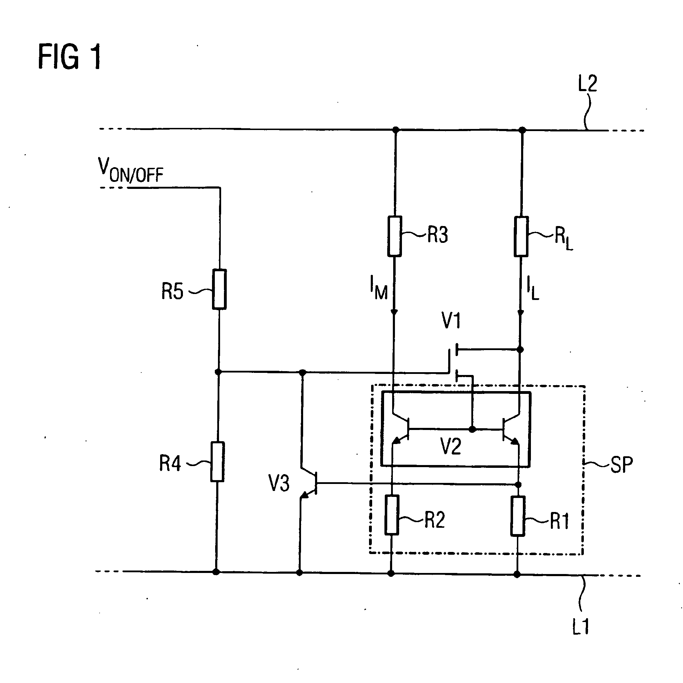

Diese Aufgabe wird gelöst mit einer Schaltung mit den Merkmalen nach Anspruch 1. Durch den zwischen der ersten Versorgungsleitung und der Last geschalteten Stromspiegel wird auf einfache Weise ein Messstrom erzeugt, der durch einen Messwiderstand geleitet wird und der an diesem eine zur Auswertung dienenden Messspannung zur Folge hat. Ein Schalttransistor, an den eine Schaltspannung über einen Widerstand angelegt werden kann, dient dazu, die Last stromlos zu schalten. Darüber hinaus wird mittels des Schalttransistors und eines weiteren Transistors dadurch eine Begrenzung des Laststroms erzielt, dass bei einem erhöhten Laststrom mittels des weiteren Transistors die Spannung an der Steuerelektrode des Schalttransistors abgesenkt wird, bis sich ein Gleichgewichtszustand bei einem festlegbaren Stromwert einstellt. Die genaue Funktionsweise wird anhand des in Figur 1 dargestellten Ausführungsbeispiels erläutert.

Die Überstrombegrenzung ist unabhängig von der Betriebsspannung und kann leicht an andere Verhältnisse, wie zum Beispiel höhere Ströme, angepasst werden. Die Ausgabe des Stromwertes ist linear und unipolar. Die Schwellenwerte für die Begrenzung sind leicht anpassbar und beliebig wählbar. Zusätzlich kann der Laststrom bis zum Einsatz der Strombegrenzung linear gemessen werden. Der Laststrom kann unabhängig vom Einsatz der Strombegrenzung jederzeit abgeschaltet werden. Die Lösung ist preiswert, da sie keine Spezialbausteine verwendet.

In einer vorteilhaften Form der Ausgestaltung ist eine zur beschriebenen Anordnung komplementäre Anordnung zwischen der zweiten Versorgungsleitung und der Last eingesetzt. Auf diese Weise erhält man eine bipolare Schaltung, wie sie notwendig ist, wenn der Lastwiderstand wechselseitig mit positiven und negativen Potenzialen angesteuert wird. Dann ist beispielsweise für den positiven Zweig ein komplementärer und für den negativen Zweig ein Aufbau gemäß Anspruch 1 vorzusehen. Somit kann die erfindungsgemäße Lösung sowohl uni- als auch bipolar eingesetzt werden.

Im Folgenden wird die Erfindung anhand der in den Figuren dargestellten Ausführungsbeispiele näher beschrieben und erläutert. Es zeigen:

FIG 1   eine erfindungsgemäße Schaltung in einer unipolaren Ausführung und

FIG 2   eine erfindungsgemäße Schaltung in einer bipolaren Ausführung.

FIG 1 zeigt eine unipolare Schaltung zum Messen, Begrenzen und Schalten einer Last $R_L$. Erfindungsgemäß wird der Laststrom $I_L$ über einen Transistor des Doppeltransistors V2 und den Widerstand R1 geleitet. Ist der Transistor V1 eingeschaltet (d. h. das Gate ist positiv gegenüber Source beziehungsweise $V_{ON/OFF}$ ist so hoch, dass am Verbindungspunkt von R4 und R5 das entsprechende Potenzial anliegt), so wirkt der Doppeltransistor als Stromspiegel mit folgendem Spiegelverhältnis:

$$\frac{I_M}{I_L} = \frac{R1}{R2} \, .$$

An R3 kann eine dem Messstrom proportionale Spannung gemessen werden. Über die Widerstände R1 bis R3 ist somit eine exakte Anpassung an die gewünschten Verhältnisse möglich.

Steigt der Laststrom an, so erhöht sich der Spannungsabfall über R1. Damit kann über die Basis-Emitter-Strecke des Transistors V3 ein Strom fließen. Dieser Stromfluss bewirkt einen Stromfluss vom Kollektor zum Emitter und damit eine Absenkung der Spannung am Gate von V1, bis sich ein Gleichgewichtszustand einstellt bei folgendem Strom:

$$I_L = \frac{V_{BE-V3}}{R1}.$$

Dabei ist $V_{BE-V3}$ die Spannung zwischen Basis und Emitter des Transistors V3. Somit kann der Strom durch den Lastwiderstand in Abhängigkeit von den Wertestreuungen der verwendeten Bauelemente sehr genau eingestellt werden.

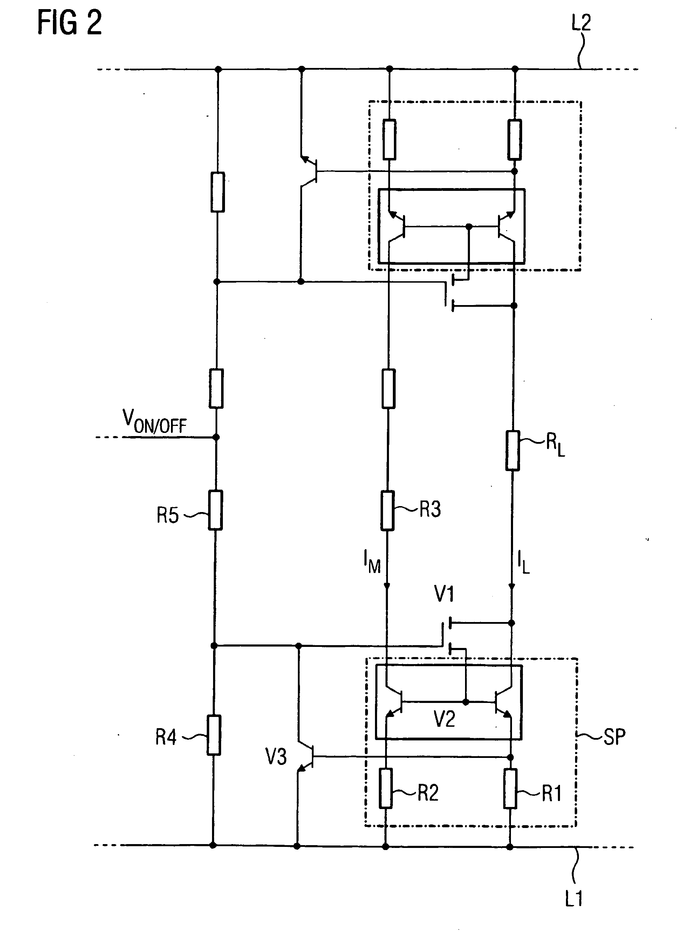

FIG 2 zeigt eine bipolare Schaltung zum Messen, Begrenzen und Schalten einer Last $R_L$. Eine solche ist notwendig, wenn der Lastwiderstand wechselseitig mit positiven und negativen Potenzialen angesteuert wird. In diesem Fall ist zwischen der Last $R_L$ und der zweiten Versorgungsleitung L2 eine der in FIG 1 dargestellten Schaltung komplementäre Schaltung eingefügt. Die Berechnung des komplementären Teils erfolgt analog wie unter FIG 1 beschrieben.

Zusammenfassend betrifft die Erfindung eine Schaltung zur Messung, Begrenzung und Schaltung eines Laststromes an einer Last. Um eine derartige Schaltung mit einer hohen Genauigkeit in der Strommessung und mit einer niedrigen Streuung zu erreichen, wird vorgeschlagen, dass durch einen zwischen einer ersten Versorgungsleitung und einer Last geschalteten Stromspiegel ein Messstrom erzeugt wird, der durch einen Messwiderstand geleitet wird und der an diesem eine zur Auswertung dienenden Messspannung zur Folge hat. Ein Schalttransistor, an den eine Schaltspannung über einen Widerstand angelegt werden kann, dient dazu, die Last stromlos zu schalten. Darüber hinaus wird mittels des Schalttransistors und eines weiteren Transistors dadurch eine Begrenzung des Laststroms erzielt, dass bei einem erhöhten Laststrom mittels des weiteren Transistors die Spannung an der Steuerelektrode des Schalttransistors abgesenkt wird, bis sich ein Gleichgewichtszustand bei einem festlegbaren Stromwert einstellt.

**Patentansprüche**

1. Schaltung zur Messung, Begrenzung und Schaltung eines Laststromes ($I_L$) an einer Last ($R_L$), bei der zwischen einer ersten Versorgungsleitung (L1) und der Last ($R_L$) ein Stromspiegel (SP) mit einem Doppeltransistor (V2) eingesetzt ist, der mittels eines Schalttransistors (V1) ansteuerbar ist, wobei der Stromspiegel (SP) einen ersten Widerstand (R1) und einen zweiten Widerstand (R2) aufweist, die einen gespiegelten Messstrom ($I_M$) gemäß der Beziehung $\frac{I_M}{I_L} = \frac{R1}{R2}$ zur Folge haben, wobei an einem zwischen dem Doppeltransistor (V2) und einer zweiten Versorgungsleitung (L2) der Last ($R_L$) geschalteten Messwiderstand (R3) eine zum Messstrom ($I_M$) proportionale Messspannung abfällt, wobei die Steuerelektrode des Schalttransistors (V1) über einen vierten Widerstand (R4) und einen zu diesem parallel geschalteten Transistor (V3) mit der ersten Versorgungsleitung (L1) verbunden ist, wobei eine Schaltspannung ($V_{ON/OFF}$) an einen fünften Widerstand (R5) anlegbar ist, der ebenfalls mit der Steuerelektrode des Schalttransistors (V1) verbunden ist und wobei die Steuerelektrode des Transistors (V3) an einer Verbindung des ersten Widerstands (R1) mit dem Doppeltransistor (V2) angeschlossen ist.

2. Schaltung nach Anspruch 1,
   wobei eine zur beschriebenen Anordnung komplementäre Anordnung zwischen der zweiten Versorgungsleitung (L2) und der Last ($R_L$) eingesetzt ist.

**Claims**

1. Circuit for measuring, limiting and switching a load current ($I_L$) on a load ($R_L$), in which a current mirror (SP) with a double transistor (V2) is used between a first supply line (L1) and the load ($R_L$), said double transistor being controllable by means of a switching transistor (V1), with the current mirror (SP) having a first resistor (R1) and a second resistor (R1), which result in a mirrored measurement current ($I_M$) according to the condition $\frac{I_M}{I_L} = \frac{R1}{R2}$, with a measurement voltage which is proportional to the measurement current ($I_M$) dropping at a measuring resistor (R3) connected between the double transistor (V2) and a second supply line (L2) of the load ($R_L$), with the control electrode of the switching transistor (V1) being connected to the first supply line (L1) by way of a fourth resistor (R4) and a transistor (V3) which is connected in parallel hereto, with it being possible to apply a switching voltage ($V_{ON/OFF}$) to a fifth resistor (R5) which is likewise connected to the control electrode of the switching transistor (V1) and with the control electrode of the transistor (V3) being connected to the double transistor (V2) at a link of the first resistor (R1).

2. Circuit according to claim 1, with an arrangement which is complementary to the described arrangement being used between the second supply line (L2) and the load ($R_L$).

**Revendications**

1. Circuit pour mesurer, pour limiter et pour commuter un courant ($I_L$) de charge sur une charge ($R_L$), dans lequel il est inséré entre une première ligne (L1) d'alimentation et la charge ($R_L$) un miroir de courant (SP) ayant un double transistor (V2), qui peut être commandé au moyen d'un transistor (V1) de commutation, dans lequel le miroir de courant (SP) a une première résistance (R1) et une deuxième résistance (R2) qui ont pour conséquence un courant ($I_M$) de mesure en miroir suivant la relation

$$\frac{I_M}{I_L} = \frac{R1}{R2} \quad,$$ dans lequel une tension de mesure proportionnelle au courant ($I_M$) de mesure chute sur une résistance (R3) de mesure montée entre le double transistor (V2) et une deuxième ligne (L2) d'alimentation, l'électrode de commande du transistor (V1) de commutation étant reliée à la première ligne (L1) d'alimentation par une quatrième résistance (R4) et par un transistor (V3) monté en parallèle à celle-ci, une tension ($V_{ON/OFF}$) de commutation pouvant être appliquée à une cinquième résistance (R5) qui est reliée également à l'électrode de commande du transistor (V1) de commutation et dans lequel l'électrode de commande du transistor (V3) est raccordée à une liaison de la première résistance (R1) au transistor (V2) double.

2. Circuit suivant la revendication 1, dans lequel un agencement complémentaire de l'agencement décrit est inséré entre la deuxième ligne (L2) d'alimentation et la charge (RL).

FIG 1

# FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10226082 A1
- US 6316967 B1